# DEMANDE DE BREVET EUROPEEN

(11) **EP 0 924 454 A1**
(43) Date de publication de la demande: **23.06.1999**
(21) Numéro de dépôt: 98403158.3
(22) Date de dépôt: 15.12.1998
(51) Int. Cl.: F16M 13/02

(54) **Dispositif support de blocs à châssis pivotant**

(30) Priorité: 23.12.1997 FR 9716316
(71) Demandeur: SAGEM SA, 75116 Paris (FR)
(72) Inventeur: Raphal, Francis, 75013 Paris (FR); Smoljanovic, Yvon, 91410 Corbreuse (FR)
(74) Mandataire: Fruchard, Guy

(57) **Abrégé**

Le dispositif support comprend une embase (1) portant des goussets (3) comportant chacun une rainure (5) débouchant sur un bord du gousset correspondant, les goussets portant un châssis (4) comportant des ergots de pivotement (10) et des organes de butée (11) s'étendant en saillie par rapport aux côtés latéraux du châssis jusque dans les rainures (5) des goussets.

## Description

La présente invention concerne un dispositif support, notamment bien que non exclusivement un dispositif support de blocs répétiteurs dans un réseau de télécommunications.

On sait que dans un réseau de télécommunications il est nécessaire pour transmettre des communications sur une grande distance de disposer à intervalles réguliers des blocs répétiteurs destinés à compenser les atténuations de signal résultant de sa propagation dans un milieu de plus en plus perturbé.

Afin d'assurer une continuité de fonctionnement dans le cas d'une défaillance d'un bloc répétiteur, les blocs répétiteurs sont généralement disposés par paires dans un boîtier comportant une embase supportant des organes de connexion au réseau. Afin de minimiser l'encombrement, les blocs répétiteurs sont fixés sur un châssis et sont plaqués contre l'embase. La paroi latérale du boîtier constitue alors un obstacle à l'extraction des blocs. Afin de pouvoir démonter les blocs, le châssis est donc monté de façon amovible sur des goussets portés par l'embase. Le châssis amovible est fixé aux goussets par des boulons. Lorsqu'un opérateur doit intervenir sur un bloc répétiteur, il doit tout d'abord extraire le châssis du boîtier afin de pouvoir accéder aux blocs répétiteurs portés par le châssis. L'opérateur doit alors supporter le châssis d'une main et extraire le bloc répétiteur avec l'autre main, ce qui est une opération d'autant plus mal aisée que le bloc répétiteur restant doit être maintenu connecté et le boîtier portant les blocs répétiteurs est généralement fixé en haut d'un mat à proximité des antennes de transmission.

On connaît par ailleurs des documents US-A-4 314 734 et UK-A-2 118 782 des boîtiers dans lesquels sont montés des châssis basculants.

Selon l'invention, on propose un dispositif support comprenant une embase portant des goussets sur lesquels est monté un châssis amovible ayant des côtés latéraux s'étendant en regard des goussets, chaque gousset comportant une rainure débouchant sur un bord de celui-ci et le châssis comportant des ergots de pivotement et des organes de butée espacés des ergots de pivotement, les ergots de pivotement et les organes de butée s'étendant en saillie par rapport aux côtés latéraux du châssis jusque dans les rainures des goussets, caractérisé en ce que chaque rainure comporte une première partie inclinée dans laquelle s'étend l'organe de butée correspondant, cette première partie débouchant sur un bord frontal du gousset correspondant et ayant une largeur très supérieure à un diamètre des ergots de pivotement, et au moins une deuxième partie s'étendant vers le bas à partir d'une extrémité inférieure de la première partie et ayant une largeur inférieure à la première partie.

Ainsi, le châssis est normalement disposé dans une position d'encombrement minimal dans laquelle les blocs sont parallèles à l'embase et lorsque l'on souhaite accéder aux blocs portés par le châssis, il suffit de faire pivoter le châssis autour des ergots de pivotement jusqu'à ce que les organes de butée soient en appui sur un côté des rainures et le châssis se trouve alors maintenu par les organes de butée selon une orientation permettant d'accéder aux blocs répétiteurs. En outre, la grande largeur de la première partie permet une introduction aisée des ergots de pivotement lors de la mise en place du châssis et un débattement important du châssis tandis que la largeur réduite de la deuxième partie assure un maintien précis des ergots de pivotement.

De préférence, chaque rainure comporte une troisième partie s'étendant vers le bas à partir d'une extrémité inférieure de la deuxième partie et formant une chicane avec celle-ci. Ainsi, lorsqu'une traction est exercée sur un bloc répétiteur pour l'extraire du châssis, on évite un déboîtement du châssis.

Selon encore une caractéristique avantageuse de l'invention, la rainure comporte un bord arrière vertical entre la première et la deuxième partie. Lors de la mise en place du châssis, ce bord arrière assure ainsi un guidage des ergots de pivotement vers la deuxième partie de la rainure.

D'autres caractéristiques et avantages de l'invention ressortiront encore à la lecture de la description qui va suivre d'un exemple particulier non limitatif de l'invention, en référence aux figures ci-jointes parmi lesquelles :
- la figure 1 est une vue en perspective partielle, couvercle retiré, d'un dispositif support selon l'invention,
- la figure 2 est une vue en perspective agrandie d'un gousset et de la partie de châssis en regard.

En référence aux figures, le dispositif support selon l'invention se présente de façon connue en soi sous forme d'un boîtier comprenant une embase 1 portant des organes de connexion 2 et un couvercle non représenté monté pour pivoter le long du bord supérieur de l'embase.

Selon l'invention, des goussets généralement désignés en 3, par exemple des goussets en tôle métallique pliée, sont fixés à l'embase 1 et s'étendent perpendiculairement à celle-ci de part et d'autre d'un châssis amovible 4.

Dans le mode de réalisation illustré chaque gousset 3 comporte une rainure 5 réalisée sous forme d'une fente dans la tôle, chaque rainure comportant une première partie inclinée 5.1 débouchant sur un bord frontal du gousset, une seconde partie 5.2 s'étendant vers le bas à partir de l'extrémité inférieure de la première partie et ayant une pente inversée par rapport à celle-ci, et une troisième partie 5.3 s'étendant vers le bas à partir de l'extrémité inférieure de la deuxième partie selon une orientation sensiblement identique à celle de la première partie et formant une chicane avec la deuxième partie. Entre la première partie 5.1 et la deuxième partie 5.2, la rainure 5 comporte un bord arrière vertical 6. Au-dessus de la rainure 5, chaque gousset comporte une fente sensiblement horizontale 7 débouchant sur le bord frontal du gousset. Chaque gousset 3 comporte un talon 8 qui est fixé à l'embase. A proximité du talon 8 et à sa partie supérieure, chaque gousset comporte une patte 9 repliée parallèlement à l'embase 1.

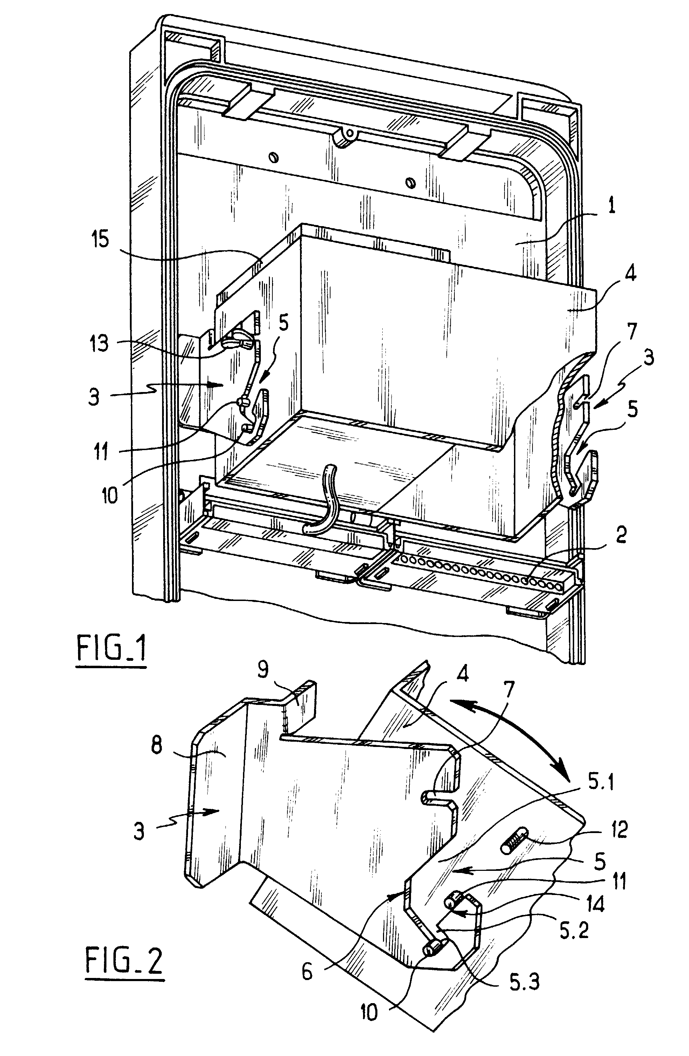

Le châssis 4 de forme parallélépipèdique, portant des blocs 15 dont un seul a été représenté sur la figure 1, est également réalisé en tôle métallique et comporte sur chacun de ses côtés latéraux un ergot de pivotement 10 s'étendant en saillie par rapport au côté correspondant de préférence en dessous du centre de gravité du châssis 4 ainsi qu'un organe de butée 11 disposé au-dessus de l'ergot de pivotement en étant espacé de celui-ci et s'étendant également en saillie par rapport au côté latéral du châssis.

Dans le mode particulier illustré, le châssis comporte également une vis de verrouillage 12 s'étendant en saillie par rapport au côté latéral du châssis, de préférence au-dessus du centre de gravité du châssis 4 et sur laquelle est monté un écrou de verrouillage 13 (figure 1).

Lors de la mise en place du châssis sur l'embase, celui-ci est présenté dans une position inclinée et les ergots de pivotement 10 sont engagés dans les premières parties 5.1 des goussets 3. Les ergots de pivotement 10 sont guidés par les bords arrière verticaux 6 vers les deuxièmes parties 5.2 puis vers les troisièmes parties 5.3 des rainures 5 jusqu'à venir en appui dans le fond de ces rainures. La distance entre les ergots de pivotement 10 et les organes de butée 11 est prévue pour que chaque organe de butée 11 s'étende alors dans la première partie 5.1 de la rainure correspondante, celle-ci ayant une largeur très supérieure au diamètre de l'ergot de pivotement 10 afin de permettre un débattement de l'organe de butée 11. Sous l'effet du poids du châssis, celui-ci s'incline jusqu'à ce que les organes de butée 11 viennent en appui sur les bords avant 14 des parties 5.1 des rainures 5 comme illustré sur la figure 2. Dans cette position le châssis 4 est supporté de façon stable par les goussets 3 et est incliné par rapport à l'embase 1, ce qui permet d'introduire ou d'extraire aisément les blocs répétiteurs.

Le châssis 4 est ensuite basculé vers l'embase comme illustré par la flèche en trait épais sur la figure 2 jusqu'à venir en appui contre les pattes 9. Dans ce mouvement, les vis de verrouillage 12 s'engagent'dans les fentes 7 des goussets 3 puis les écrous 13 sont serrés pour assurer un blocage du châssis 4 dans une position d'encombrement minimal. Le couvercle du boîtier est ensuite refermé pour assurer la protection des blocs répétiteurs.

Bien entendu l'invention n'est pas limitée au mode de réalisation décrit et on peut y apporter des variantes de réalisation sans sortir du cadre de l'invention tel que défini par les revendications.

En particulier, bien que les goussets du dispositif support selon l'invention aient été illustrés sous forme de tôle métallique découpée et pliée, on peut réaliser des goussets sous forme de blocs massifs comportant des rainures creusées dans les faces des goussets en regard des côtés latéraux du châssis 4.

Bien que les ergots de pivotement 10 et les organes de butée 11 aient été illustrés sous forme de pions métalliques fixés dans la paroi du châssis 4, par exemple par rivetage, on peut également réaliser ces éléments par découpage de pattes dans la paroi du châssis 4 et pliage de ces pattes perpendiculairement à la paroi latérale du châssis.

Bien que les rainures 5 aient été représentées sous forme de fentes en zigzag débouchant sur le bord avant des goussets on peut les réaliser sous forme d'un V débouchant sur le bord avant ou sur le bord supérieur des goussets.

On peut également prévoir que les organes de butée 11 servent également d'organes de verrouillage, les pions illustrés étant alors remplacés par des vis et les rainures 7 étant réalisées dans le bord arrière de la rainure 5.

## Revendications

1. Dispositif support comprenant une embase (1) portant des goussets (3) sur lesquels est monté un châssis amovible (4) ayant des côtés latéraux s'étendant en regard des goussets (3), chaque gousset comportant une rainure (5) débouchant sur un bord de celui-ci et le châssis comportant des ergots de pivotement (10) et des organes de butée (11) espacés des ergots de pivotement, les ergots de pivotement (10) et les organes de butée (11) s'étendant en saillie par rapport aux côtés latéraux du châssis jusque dans les rainures (5) des goussets, caractérisé en ce que chaque rainure (5) comporte une première partie (5.1) inclinée dans laquelle s'étend l'organe de butée (11) correspondant, cette première partie débouchant sur un bord frontal du gousset correspondant et ayant une largeur supérieure à un diamètre des ergots de pivotement (10), et au moins une deuxième partie (5.2) s'étendant vers le bas à partir d'une extrémité inférieure de la première partie et ayant une largeur inférieure à la première partie.

2. Dispositif support selon la revendication 1, caractérisé en ce que chaque rainure (5) comporte une troisième partie (5.3) s'étendant vers le bas à partir d'une extrémité inférieure de la deuxième partie et formant une chicane avec celle-ci.

3. Dispositif support selon la revendication 1, caractérisé en ce que la rainure (5) comporte un bord arrière vertical (6) entre la première partie (5.1) et la deuxième partie (5.2).

4. Dispositif support selon l'une des revendications 1 à 3, caractérisé en ce que les goussets (3) sont en tôle métallique et les rainures (5) sont réalisées sous forme de fentes dans la tôle.

5. Dispositif support selon la revendication 4, caractérisé en ce que les goussets comportent des pattes (9) repliées pour former des butées pour le châssis amovible (4) à la partie supérieure des goussets.

6. Dispositif support selon l'une des revendications précédentes, caractérisé en ce que les ergots de pivotement (10) sont disposés en dessous du centre de gravité du châssis(4).
